Europäisches Patentamt

European Patent Office

Office européen des brevets

(19)

(11) Numéro de publication: **0 335 794**
**A1**

## (12) DEMANDE DE BREVET EUROPEEN

(21) Numéro de dépôt: **89400868.9**

(22) Date de dépôt: **29.03.89**

(51) Int. Cl.4: **C 30 B 29/48**
**C 30 B 13/02**

(30) Priorité: **01.04.88 FR 8804370**

(43) Date de publication de la demande:
**04.10.89 Bulletin 89/40**

(84) Etats contractants désignés: **DE GB NL**

(71) Demandeur: **SAT Société Anonyme de**
**Télécommunications**
**41, rue Cantagrel**
**F-75631 Paris Cedex 13 (FR)**

(72) Inventeur: **Royer, Michel**
**29 rue Claude Decaen**
**F-75012 Paris (FR)**

**Jean, Bernard Raymond**
**11 Allée André Derain**
**F-91600 Savigny sur Orge (FR)**

**Durand, Alain René**
**45 rue Jules Ferry**
**F-86000 Poitiers (FR)**

**Triboulet, Robert Georges**
**26 rue de Terre Neuve**
**F-92190 Meudon (FR)**

(74) Mandataire: **Bloch, Gérard et al**
**2, square de l'Avenue du Bois**
**F-75116 Paris (FR)**

(54) **Procédé de préparation d'un lingot cristallin de HgCdTe.**

(57) On prépare un lingot (1) selon un procédé T.H.M. ("Traveling Heater Method"), en déplaçant, le long d'une enceinte (2) cylindrique, un four (12) annulaire portant à une température T un mélange fondu (4) solvant, de façon à dissoudre progressivement un matériau source (3) à l'extrémité supérieure du mélange fondu (4) et obtenir, à son extrémité inférieure, la cristallisation du lingot (1) à préparer. Pendant ce déplacement, on entraîne l'enceinte (2) en rotation (6) autour de son axe, à vitesse variable et alternativement inversée

Le procédé de l'invention permet de préparer un lingot monocristallin dans lequel les variations de composition sont réduites de façon notable. Il permet ainsi la reduction des coûts de fabrication des détecteurs infrarouges, ou des autres composants réalisés dans le lingot.

FIG.2

**Description**

### Procédé de préparation d'un lingot cristallin de HgCdTe

La présente invention a pour objet un procédé de préparation d'un lingot cristallin de tellurure de cadmium-mercure HgCdTe, de composition sensiblement uniforme, selon le procédé T.H.M. ("Traveling Heater Method"), dans lequel:

- on dispose, à la partie inférieure d'une enceinte sensiblement cylindrique et d'axe vertical, un mélange solidifié de Te, Hg, et Cd en proportions égales à celles de la phase liquide, à une température prédeterminée, du lingot à préparer,

- on dispose, en contact avec le mélange solidifié, un cylindre de matériau source comprenant les éléments Te, Hg, et Cd en proportions égales à celles du lingot à préparer,

- on ferme l'enceinte, sous vide,

- on chauffe la partie inférieure de l'enceinte contenant le mélange solidifié, pour le faire fondre et amener le mélange fondu à ladite température prédeterminée, et,

- on déplace la partie chauffée le long de l'enceinte pour dissoudre progressivement le matériau source à l'extrémité supérieure du mélange fondu et obtenir, à son extrémité inférieure, la cristallisation du lingot à préparer.

Les lingots cristallins ainsi préparés sont utilisés pour fabriquer, par exemple, des détecteurs de rayonnements infrarouges. Ces détecteurs sont obtenus par des procédés connus de formation de couches dopées dans un substrat taillé dans un tel lingot, de façon à ce que ces couches dopées forment des jonctions PN, PIN, ou à avalanche, par exemple.

On connait déjà un procédé du type défini ci-dessus, décrit dans le brevet français publié sous le N° 2 502 190, au nom de la demanderesse. Ce procédé permet la préparation de lingots cristallins en forme de cylindre circulaire de taille relativement importante. Toutefois, ces lingots sont de structure polycristalline, c'est à dire comprenant une pluralité de monocristaux d'orientation différente. Ils présentent donc des joints de grains et des défauts cristallins. Ceci rend inutilisables une partie des détecteurs réalisés à partir de ces lingots, précisément ceux qui sont réalisés dans les parties des lingots comportant les joints de grains ou les défauts. De plus, les lingots réalisés selon ce procédé ne présentent pas une homogénéité parfaite, c'est à dire que la proportion de cadmium par rapport à celle de mercure, proportion définie par le terme x dans la formule:

$Hg_{1-x}Cd_xTe$

n'est pas rigoureusement constante et égale à celle souhaitée, c'est à dire celle du matériau source. Ceci est un inconvénient, car, comme cela est connu, la longueur d'onde des rayonnements infrarouge pour lesquelles la sensiblité d'un détecteur est maximale dépend directement de la composition, définie par le terme x, du cristal dans lequel ce détecteur est réalisé. Des variations dans la composition d'un même lingot sont donc à l'origine de variations dans les performances des détecteurs réalisés dans ce lingot, ce qui n'est pas souhaitable.

On connait par ailleurs, et par la demande française enregistrée sous le N° 86 00 769, au nom de la demanderesse, un procédé du type T.H.M. qui permet de fabriquer des lingots monocristallins en forme de cylindre circulaire de taille relativement importante, notamment grâce l'utilisation d'un germe monocristallin, conjointement avec la formation d'une zone d'adaptation entre le germe et la zone de solvant. Ce procédé présente toutefois l'inconvénient d'une mise en oeuvre plus complexe et plus longue que le procédé précédent, et, de plus, les variations de la composition du lingot obtenu restent relativement importantes.

La présente invention vise à pallier les inconvénients précédents, en procurant un procédé de préparation de lingots monocristallins de HgCdTe dont la mise en oeuvre est simple et rapide, et qui permet de réduire les variations de composition des lingots obtenus.

A cet effet, elle a pour objet un procédé du type défini ci-dessus, caractérisé par le fait que, pendant le déplacement de la zone chauffée, on entraîne l'enceinte en rotation autour de son axe, à vitesse variable et alternativement inversée.

Avec le procédé de l'invention, on obtient, sans utilisation d'un germe monocristallin, un lingot monocristallin, dont, de plus, les variations de composition, tant dans un plan de section droite que le long de l'axe, sont notablement plus faibles qu'avec le procédé de l'art antérieur. Ce dernier résultat, à propos de l'homogénéité axiale du lingot, est particulièrement surprenant. En effet, la rotation de l'enceinte crée une agitation qui ne peut affecter que la zone à l'état fluide à l'intérieur de l'enceinte, dont les particules se trouvent alors entraînées dans un mouvement horizontal. Or, dans le procédé T.H.M., la zone à l'état fluide a la forme d'une galette horizontale de hauteur relativement faible. Ainsi, on pourrait s'attendre à ce qu'un mouvement d'agitation dans un plan horizontal, de plus limité à une tranche de dimension verticale faible, ait une influence négligeable sur l'homogénéité, selon l'axe vertical, du lingot obtenu. Or, il n'en est rien, puisque celle-ci se trouve nettement améliorée. Par ailleurs, le lingot obtenu ne présente pas les défauts macroscopiques fréquents qui altèrent habituellement la qualité cristalline des alliages HgCdTe.

De plus, le procédé de l'invention, comparé au procédé de l'art antérieur, permet, sans diminution des qualités du lingot obtenu, de travailler à température sensiblement plus basse, avec une vitesse de déplacement vertical de l'enceinte, ou vitesse de "tirage", plus grande, et avec une enceinte de qualité inférieure. La mise en oeuvre du procédé de l'invention se trouve ainsi simplifiée.

Avantageusement, on superpose à l'entraînement en rotation à vitesse variable et alternativement inversée, un entraînement à vitesse constante, inférieure à sensiblement un tour par minute.

Alors, les variations résiduelles de composition du lingot obtenu, dans ses plans de section droite, se trouvent encore réduites, même en présence d'inhomogénéités de chauffe du four annulaire autour du mélange solvant.

Avantageusement encore, avant de disposer le mélange solidifié dans la partie inférieure de l'enceinte, on dispose, au fond de celle-ci, un germe monocristallin de HgCdTe pourvu d'une face plane, polie et orientée..

Alors, on obtient un lingot monocristallin dont l'orientation est la même que celle du germe, c'est à dire que cette orientation peut être choisie.

La présente invention sera mieux comprise à la lecture de la description suivante de la mise en oeuvre préférée du procédé de l'invention, faite en se référant aux dessins annexés, sur lesquels:

- la figure 1 représente une vue schématique d'un dispositif permettant la mise en oeuvre du procédé de l'invention, de préparation d'un lingot de HgCdTe,

- la figure 2 représente une vue schématique, en coupe, de l'enceinte du dispositif de la figure 1 et de son contenu en cours de préparation du lingot,

- la figure 3 représente une vue schématique, en coupe, de l'enceinte du dispositif de la figure 1 et de son contenu en cours de préparation du lingot, pour une variante de mise en oeuvre du procédé de l'invention,

- la figure 4 représente un diagramme temporel des variations de la vitesse de rotation, autour de son axe, de l'enceinte du dispositif de la figure 1, et,

- la figure 5 représente les variations de composition, selon son axe, d'un lingot obtenu avec le procédé de l'invention, comparées à celles d'un lingot obtenu avec un procédé de l'art antérieur.

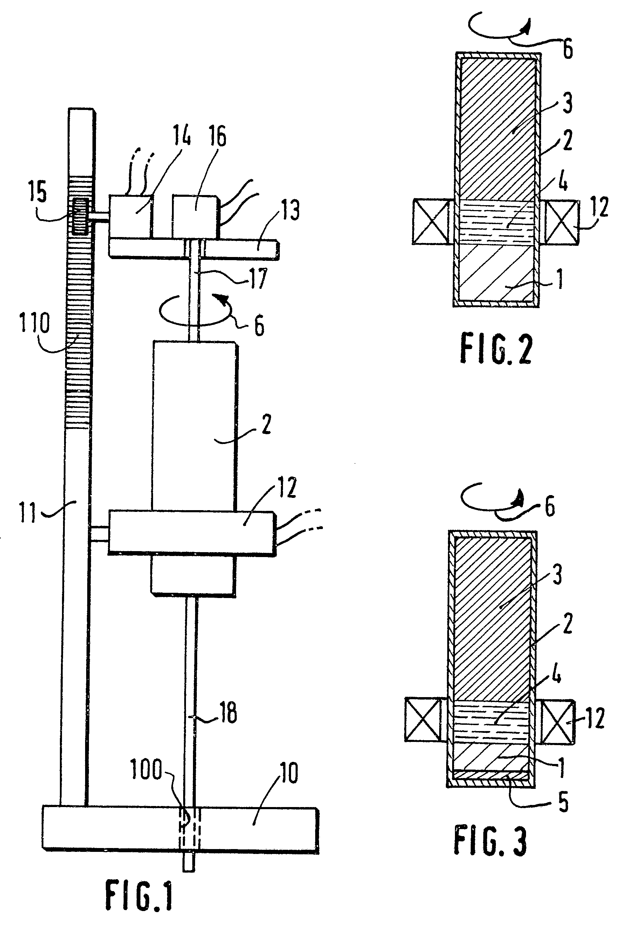

En se référant à la figure 1, un dispositif pour la préparation de lingots cristallins de HgCdTe est maintenant décrit.

Ce dispositif comprend une plate-forme 10, formant base et qui supporte un bras vertical 11.

Un four annulaire 12 est monté solidaire du bras 11, sensiblement à mi-hauteur de celui-ci, et disposé pour que son axe de symétrie rotationnelle soit vertical.

Une plate-forme 13, montée mobile en translation verticale par rapport au bras 11, au dessus du four 12, et guidée par des moyens non représentés car classiques, est entraînée en translation verticale par un moteur 14 dont l'arbre de sortie, horizontal, entraîne une roue dentée 15 coopérant avec une crémaillère 110 prévue sur le bras 11.

La plate-forme mobile 13 supporte un moteur électrique 16 dont l'arbre de sortie, vertical et dirigé vers le bas, traverse la plate-forme 13 et se trouve solidaire d'une tige 17, ici en verre.

Une enceinte 2, ici en forme de cylindre circulaire allongé, réalisée en silice fondue, est rendue solidaire de la tige 17 par l'intermédiaire de sa base supérieure. L'enceinte 2 traverse le four annulaire 12. La base inférieure de l'enceinte 2 est solidaire d'une autre tige de verre 18 qui se trouve maintenue en position verticale par passage à travers un trou traversant 100, prévu dans la plate forme 10.

L'ensemble est prévu pour que l'amplitude du mouvement de translation verticale de la plate-forme 13 soit au moins égal à la hauteur de l'enceinte 2, de telle sorte que n'importe quelle partie de cette enceinte 2 puisse se trouver chauffée par le four annulaire 12. Naturellement, celui-ci, ainsi que les moteurs 14 et 16, sont pourvus de connexions électriques raccordées à des circuits électriques et électroniques, non représentés car classiques, qui permettent de les commander.

La mise en oeuvre du procédé T.H.M. de l'invention, à l'aide du dispositif décrit ci- dessus, pour préparer un lingot monocristallin de $Hg_{1-x}Cd_xTe$, dans lequel la fraction x de cadmium est sensiblement égale à 0,21, est maintenant décrite.

Comme cela est connu, et décrit dans le brevet français au nom de la demanderesse, publié sous le N° 2 502 190, on commence tout d'abord par choisir, ou prédéterminer, la température T à laquelle sera chauffé le contenu de la partie de l'enceinte 2 se trouvant à l'intérieur du four 12. Ici, la fraction x étant inférieure à 0,5, on choisit une température T de 600°C. Si la fraction x était supérieure à 0,5, on choisirait une température T un peu plus élevée, par exemple de l'ordre de 650°C. On notera dans tous les cas que ces températures sont de 50°C inférieures à celles qui sont utilisées pour la mise en oeuvre du procédé de l'art antérieur décrit dans le brevet N° 2 502 190.

Ensuite, on détermine les proportions qui seraient celles de Hg, Cd, et Te dans la phase liquide du lingot à préparer, à la température de 600°C, proportions qui seront celle du mélange destiné à servir de solvant. Comme cela est connu, ces proportions peuvent être déterminées théoriquement, à partir de la connaissance de la valeur de la température T et de la valeur de la fraction x dans le lingot à préparer, mais elles peuvent également être déterminées expérimentalement de la façon qui va maintenant être rappelée brièvement.

Pour cette détermination expérimentale, on prépare un lingot de HgCdTe par le procédé T.H.M. bien connu, dans lequel le solvant est du tellure pur, à partir d'un matériau source comprenant les éléments Te, Hg, et Cd en proportions égales à celles du lingot à préparer, le four 12 étant réglé pour chauffer le solvant à la température T. De façon connue, la composition ,selon son axe, du lingot obtenu, n'est pas constante au voisinage de la tête du lingot, c'est à dire de la partie qui a été cristallisée en premier, mais le devient au voisinage de la queue du lingot. Ceci tient au fait que la composition du solvant varie pendant la cristallisation au voisinage de la tête du lingot, alors qu'elle atteint une composition d'équilibre pendant la cristallisation au voisinage de la queue du lingot, composition d'équilibre qui correspond précisément à celle de la phase liquide, à la température T, du lingot à préparer. Il suffit donc de refroidir brutalement la zone de solvant, au moment de la cristallisation de la queue du lingot, et d'analyser la composition de la zone de solvant refroidi pour déterminer experimentalement les proportions de Hg, Cd, et Te qui sont recherchées.

On prépare ensuite, de façon connue, un mélange solidifié de Hg, Cd, et Te respectant ces proportions, et on le dispose dans la partie inférieure de l'enceinte 2.

On dispose alors, en contact avec ce mélange, un cylindre 3 de matériau source, ici obtenu par fusion et solidification et comprenant les éléments Te, Hg, et Cd en proportions égales à celles du lingot cristallin à préparer.

On ferme ensuite l'enceinte 2, sous vide, on la dispose pour que sa partie inférieure se trouve à l'intérieur du four 12 et on commande celui-ci pour chauffer le mélange solidifié, le faire fondre, et amener le mélange fondu à la température T, ici égale à 600°C.

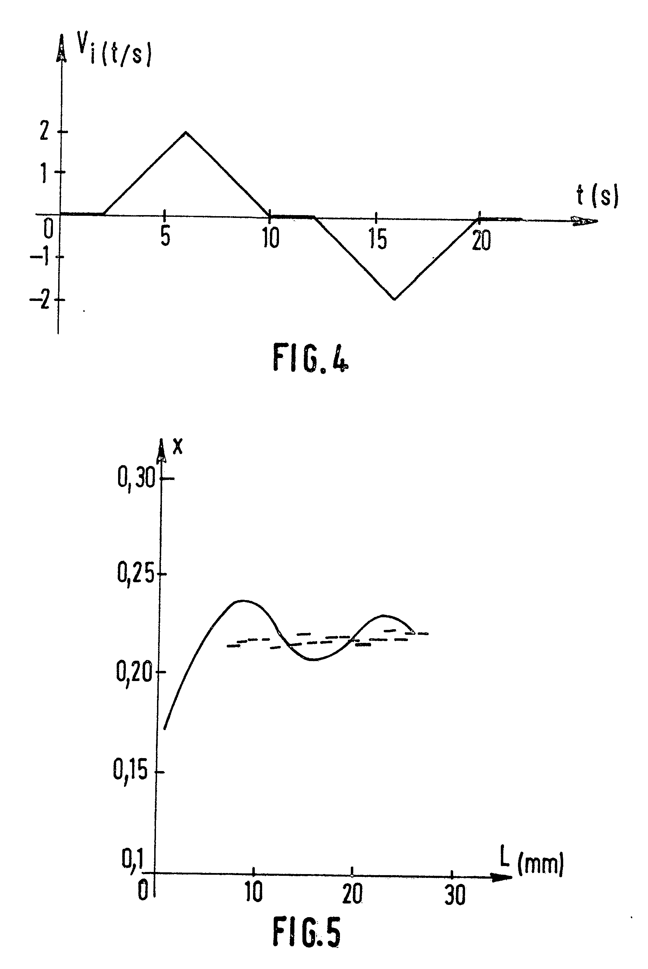

On commande alors le moteur 16 pour que l'enceinte 2 se trouve entraînée en rotation autour de son axe, à une vitesse $V_i$ variable et alternativement inversée, c'est-à-dire dans un sens de rotation puis dans l'autre sens et ainsi de suite. Le diagramme de la figure 4 fournit un exemple typique pour les variations de la vitesse $V_i$. Après un palier de 2 secondes pendant lequel la vitesse de rotation est nulle, une accélération uniforme est appliquée, pour que la vitesse passe de 0 à 2 tours par seconde en 4 secondes, de façon linéaire. Ensuite, l'acceleration change de signe, si bien que la vitesse passe de 2 tours par seconde à 0, en 4 secondes. Un second palier de 2 secondes a lieu, pendant lequel la vitesse reste nulle, pour ensuite subir les mêmes variations que précédemment, mais en sens inverse. Un cycle identique au précédent recommence ensuite, et ainsi de suite.

Simultanément à l'entraînement en rotation, on commande le moteur 14 afin de déplacer la partie chauffée le long de l'enceinte 2 pour dissoudre progressivement le matériau source 3 à l'extrémité supérieure du mélange fondu 4 et obtenir, à son extrémité inférieure, la cristallisation du lingot 1 à préparer, comme le montre la figure 2.

Avec le procédé de l'invention, on obtient un lingot monocristallin dont les variations de composition sont particulièrement faibles, comme le montre la figure 5. Sur cette figure, la courbe en trait plein représente les variations de la fraction x de cadmium dans un lingot obtenu par le procédé du brevet déjà cité, en fonction de la distance L, selon l'axe du lingot, entre l'échantillon mesuré et la base inférieure du lingot. Les tirets représentent les valeurs correspondantes obtenues pour un lingot préparé avec le procédé de l'invention.

Lorsque le four 12 n'est pas parfaitement homogène, il est avantageux de superposer à l'entraînement en rotation à la vitesse $V_i$, un entraînement à une vitesse constante $V_o$, ici égale à 1/6ème de tour par minute, et de façon plus générale, inférieure à sensiblement un tour par minute.

Lorsque l'on souhaite que le lingot monocristallin obtenu ait une orientation cristalline donnée, on peut, comme cela est connu et décrit dans la demande française enregistrée sous le N° 86 00 769, utiliser un germe d'orientation connue, qui impose l'orientation du lingot. A cet effet, comme le montre la figure 3, avant de disposer le mélange solidifié dans la partie inférieure de l'enceinte 1, on dispose, au fond de celle-ci, un germe 5 monocristallin de HgCdTe pourvu d'une face plane, polie et orientée.

Naturellement, la portée de la présente demande n'est pas limitée à la description qui vient d'être faite. C'est ainsi que, par exemple, le cylindre 3 pourrait également, et comme cela est décrit dans le brevet N° 2 502 190, être obtenu par juxtaposition de deux lingots sources cylindriques de sections complémentaires, l'un de HgTe, l'autre de CdTe, le rapport de leur sections respectives étant égal au rapport Hg/Cd du lingot à préparer.

De même, les variations de la vitesse $V_i$ de la figure 5 ne sont données qu'à titre d'exemple, et il est naturellement à la portée d'un homme de métier de prévoir d'autres lois de variations.

## Revendications

1. Procédé de préparation d'un lingot (1) cristallin de tellurure de cadmium-mercure HgCdTe, de composition sensiblement uniforme, selon le procédé T.H.M. ("Traveling Heater Method"), dans lequel :
- on dispose, à la partie inférieure d'une enceinte (2) sensiblement cylindrique et d'axe vertical, un mélange solidifié de Te, Hg, et Cd en proportions égales à celles de la phase liquide, à une température prédeterminée (T), du lingot à préparer,
- on dispose, en contact avec le mélange solidifié, un cylindre de matériau source (3) comprenant les éléments Te, Hg, et Cd en proportions égales à celles du lingot à préparer,
- on ferme l'enceinte (2), sous vide,
- on chauffe la partie inférieure de l'enceinte (2) contenant le mélange solidifié, pour le faire fondre et amener le mélange fondu (4) à ladite température prédeterminée (T), et,
- on déplace la partie chauffée le long de l'enceinte (2) pour dissoudre progressivement le matériau source (3) à l'extrémité supérieure du mélange fondu (4) et obtenir, à son extrémité inférieure, la cristallisation du lingot (1) à préparer,
procédé caractérisé par le fait que,
- pendant le déplacement de la zone chauffée, on entraîne l'enceinte (2) en rotation autour de son axe, à vitesse ($V_i$) variable et alternativement inversée.

2. Procédé selon la revendication 1, dans lequel on superpose à l'entraînement en rotation à vitesse ($V_i$) variable et alternativement inversée, un entraînement à vitesse constante ($V_o$), inférieure à sensiblement un tour par minute.

3. Procédé selon l'une des revendications 1 ou 2, dans lequel, avant de disposer le mélange solidifié dans la partie inférieure de l'enceinte (1), on dispose, au fond de celle-ci, un germe (5) monocristallin de HgCdTe pourvu d'une face plane, polie et orientée.

FIG.1

FIG.2

FIG.3

FIG.4

FIG.5

# DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,D | EP-A-0 060 744 (SOCIETE ANONYME DE TELECOMMUNICATIONS) * Revendications * & FR-A-2 502 190 (Cat.D) --- | 1 | C 30 B 29/48 C 30 B 13/02 |
| A | JOURNAL OF CRYSTAL GROWTH, vol. 30, no. 1, août 1975, pages 29-36, North-Holland Publishing Co., Amsterdam, NL; F.V. WALD et al.: "Natural and forced convection during solution growth of CdTe by the traveling heater method (THM)" * Page 31, colonne 2, lignes 26-38 * --- | 1 | |
| A,D | EP-A-0 234 984 (SOCIETE ANONYME DE TELECOMMUNICATIONS) * Revendication 1 * & FR-A-2 593 196 (Cat. D) --- | 1,3 | |
| A | FR-A-2 228 540 (COMMISSARIAT A L'ENERGIE ATOMIQUE) * Revendications 1,5,13 * --- | 1 | DOMAINES TECHNIQUES RECHERCHES (Int. Cl.4) |
| A | FR-A-2 560 225 (COMMISSARIAT A L'ENERGIE ATOMIQUE) ----- | | C 30 B |

Le présent rapport a été établi pour toutes les revendications

| Lieu de la recherche | Date d'achèvement de la recherche | Examinateur |
|---|---|---|
| LA HAYE | 10-07-1989 | COOK S.D. |